# EUROPEAN PATENT SPECIFICATION

(11) **EP 0 485 910 B1**
(45) Date of publication and mention of the grant of the patent: **28.02.1996**
(21) Application number: 91119101.3
(22) Date of filing: 09.11.1991
(51) Int. Cl.: H05K 3/34, H01B 1/20, H01B 1/22, H01L 23/498, B23K 35/22

(54) **Organic vehicle for electronic composition**
Organisches Trägermedium für elektronische Zusammensetzungen
Véhicule organique pour compositions électroniques

(30) Priority: 13.11.1990 US 612337
(43) Date of publication of application: 20.05.1992
(73) Proprietor: E.I. DU PONT DE NEMOURS AND COMPANY, Wilmington Delaware 19898 (US)
(72) Inventor: Scheiber, David Hitz, Wilmington, Delaware 19803 (US)
(74) Representative: von Kreisler, Alek, Dipl.-Chem.

(56) References cited:
- US-A- 3 357 930
- US-A- 4 674 512
- US-A- 4 692 273
- US-A- 4 994 119

## Description

This invention relates to a composition useful as a paste for electronics applications. More particularly, this invention relates to a liquid vehicle for suspending inorganic particles for use in thick film and solder paste applications.

The electronics industry uses particulate-based high-solids pastes in a variety of applications to ultimately provide conductive or dielectric capability in an electronic component. These pastes typically contain inorganic particles and an organic medium or vehicle. The inorganic particles provide the electrical functionality in the ultimate application, i.e., insulative or non-conducting inorganic particles form dielectric parts and conductive inorganic particles, primarily metals, form conductive parts. The organic medium facilitates application and control of the location of the inorganic particles. After application of the paste, the organic medium is removed by heating and the inorganic particles are sintered to form the electrically functional part. To apply the paste to the desired locations in the desired patterns, it is necessary that the paste flow well with the application method employed, such as stencil or screen printing, pressure dispensing etc. A flow modifying agent or agents is typically included in the paste formulation for the paste to have the appropriate rheology or flow characteristics. Particularly desirable rheological characteristics of the paste include high viscosity, which precludes separation or settling of the inorganic particulate in the paste, dripping, stringiness, and slumping or sagging; pseudoplasticity, which provides shear thinning for improved printing characteristics; sufficient tackiness to hold components; good transfer through the printing pattern; and clean release from the screen or stencil. A typical flow modifier for commercially available rosin-based pastes is a hydrogenated castor oil. Polysaccharide derivatives, such as ethyl cellulose are also flow modifiers when incorporated as a non-aqueous solution into high solids dispersions of particulate materials such as finely-divided metals, ceramics, oxides and glasses, as disclosed in Electronic Materials Handbook, Minges et al., "Thick Film Hybrids" ASM International, 1989 Vol. 1-Packaging, pages 339-345. Also Mastrangelo, in U.S. Patent 4,273,593, discloses hydroxypropyl cellulose as another polysaccharide derivative that is a flow modifier when incorporated with polyalkoxyalkanols into a high solid dispersion of finely-divided metals. Water soluble polysaccharides are also known for their thickening, suspending and flow modifying properties when used in very small amounts, as little as 0.03% by weight as disclosed in Industrial Gums, 2nd ed., R. Whistler ed., Academic Press, 1973, pgs. 492-494. However, substantially aqueous polysaccharide vehicles do not perform satisfactorily in electronic paste compositions because the paste presents handling problems during application, such as unacceptably short screen life due to evaporation of the water. Furthermore, in solder pastes, the water can deleteriously effect the solder reflow process. For example, the water may evaporate violently during the reflow process and splatter solder paste or solder thereby creating undesirable solder balls. Or the water may evaporate too early in the reflow process and thus not serve as a liquid phase through reflow. Lack of an adequate liquid phase through reflow can lead to solder powder oxidation and/or insufficient activator on the powder and substrate surfaces.

Effective amounts of flow modifiers, other organic ingredients, and acidic and/or basic activators, are typically so high that the organic ingredients leave a substantial residue on the solder after reflow. For example, rosin is typically present in a solder paste in the amount of 25% or greater by weight in a solder paste vehicle. For thick film paste, ethyl cellulose, as a flow modifier, is typically present in the amount of 1-3% by weight of the paste. This amount of flow modifier leaves a substantial, readily visible and potentially solder-coating residue. It is necessary to wash off the residues since the residues contain various ionic contaminants and other chemical agents which can cause shorting and product failures over time. Despite the undesirability of these residues, they have been of little concern until recently because chlorofluorocarbon solvents effectively and easily remove the residues. Today, however, considerable efforts are being made to replace such chlorofluorocarbon solvents due to their environmental impact upon the stratosphere. In addition, the failure of cleaning agents to completely remove residues from tight, hard-to-reach spots, and from under components in surface mount or fine pitch assembly operations, makes current methods and proposed alternative cleaners less effective. As a result, there arises a need for a solder paste composition which does not require cleaning of the residues remaining after reflow. To eliminate the need for cleaning, it is critical to formulate pastes in such a manner that after reflow the amount of residue is minimal and innocuous. Residue should be minimal so as to not interfere with electrical probing of the solder joint as well as for aesthetic reasons. The residue must be innocuous so it will neither cause corrosion nor provide a conductive path for leakage currents between adjacent conductors.

Similarly, in other electronic pastes, such as thick film pastes, the amount of organic ingredients should be minimized. When present in the final product, such ingredients and residues thereof are undesirable contaminants that deleteriously effect the electrical performance of the part.

US-A 4 692 273 discloses a composition in which an organo-soluble polysaccharide gum is dissolved in a glycol solvent and mixed with an aqueous mixture comprising a conductive salt and a polyacrylamide.

Therefore, it is an object of this invention to provide an electronic paste composition in which desirable rheological and flow properties of the paste are achieved with a minimal amount of a flow modifier in the vehicle. It is also an object of this invention to provide a vehicle for a solder paste which incorporates a flow modifier in such a small amount that the residue remaining after the solder paste is reflowed is essentially negligible and innocuous so that no cleaning is necessary.

The invention is directed to a composition as defined in claim 1 and an electronic paste as defined in claim 7. Further embodiments can be found in the dependent claims.

It is an unusual property of some polysaccharides that they are soluble in a few organic solvents as well as water. I have surprisingly found that excellent flow modifiers for particulate-based, high-solids pastes can be prepared by dispersing a small amount of an organo-soluble polysaccharide gum in a medium comprising a true gum solvent and a gum non-solvent.

The paste compositions of the invention contain finely divided inorganic particles suspended in an organic vehicle. The inorganic particles may be any of those conventionally included in electronic paste compositions. For example, single or multiphase metals such as tin, lead, silver, bismuth, indium, gold, platinum, palladium, copper, zinc, germanium, silicon, antimony, gallium, phosphorous, alloys thereof or mixtures thereof are suitable. Non-metallic inorganic particles including ceramics, glasses, oxides, sulfides, borides and carbides such as alumina, titanates, zirconates, stannates, manganates, borates, silicates, boro silicates, oxide glasses, lead oxides, cobalt oxides, bismuth oxides, zinc oxides, boron oxides, silica oxides, antimony oxides, magnesium oxides and mixtures thereof are also suitable. The borosilicate glasses can include, but are not limited to, lead borosilicate frits, and bismuth, cadmium, barium, calcium and other alkaline earth borosilicate frits. Oxide glasses can include, but are not limited to, aluminophosphates, aluminophosphosilicates, aluminoborophosphosilicates, phosphoborosilicates and mixtures thereof which can optionally contain alkali or alkaline earth cations to control properties of the glass such as moisture resistance, acid/base resistance and thermal expansion characteristics. The inorganic particles are normally smaller than 100 mesh (149 micron (1 micron = 1 µm)), and preferably smaller than 200 mesh (74 micron). Powder particles smaller than 325 mesh (44 micron) are also suitable for use in this invention and are preferred in thick film pastes and in some solder pastes. When using mixtures of metals or their alloys, it is possible to adjust properties such as the melting point, tensile strength, fluidity, shear strength, elongation, Brinell hardness, and density, by modifying the relative amounts of the component metals or alloys. Similarly for non-metallic mixtures, it is possible to adjust properties such as the dielectric constant, softening point, hardness, and density, by modifying the relative amounts of the non-metallic components. Conventional metal or metal alloy solder powders particularly useful for assembly soldering of electronic components include a 63% tin-37% lead solder, or a 62% tin-36% lead-2% silver solder. Other metal or metal alloy solders may also be used, such as alloys of tin-indium, tin-bismuth, or tin-lead-bismuth. The amount of inorganic particles in the electronic solder paste may range from about 65 to about 93 weight percent of the paste composition, preferably between 90 and 92 weight percent. Preferred thick film metallic inorganic particles are copper, silver, gold, platinum, palladium and other precious metals. The amount of metallic inorganic particles in a thick film conductor paste may range from about 75 to about 90 weight percent of the paste composition. Preferred thick film non-metallic inorganic particles are alumina, barium titanate; calcium titanate, strontium titanate, lead titanate, calcium zirconate, barium zirconate, magnanite calcium stannate, barium stannate, bismuth titanate, bismuth stannate, bismuth trioxides, iron oxides, zirconium orthosilicate (zircon), aluminum silicates (kyanite and mullite), magnesium orthosilicate (forsterite), lead borosilicates, calcium zinc borosilicates, lead oxides, zinc oxides and silica oxides. The amount of non-metallic inorganic particles in a thick film dielectric paste may range from about 65 to about 80 weight percent of the paste composition.

The vehicle comprises an organo-soluble polysaccharide gum dispersed in a homogeneous liquid medium. Organo-soluble polysaccharides, hereinafter referred to as polysaccharides or gums or polysaccharide gums, suitable for use in this invention include but are not limited to welan (S-130), rhamsan (S-194), xanthan, agar, hypnean, funoran, gum arabic, gum karaya, gum tragacanth, and pectin gums. Particularly preferred are welan and rhamsan gums. Welan and rhamsan are available from the Kelco Division of Merck and Company, San Diego, California. The performance of the gum in the vehicle is enhanced as the molecular weight of the gum increases, particularly when the molecular weight of the gum is 1,000,000 or above. Other high molecular weight organo-soluble polysaccharide gums which can originate from plant sources or be generated microbially or synthetically are also suitable. The polysaccharide gum may be present in the vehicle to a maximum of 1.0 weight percent, preferably 0.05 to 0.50 weight percent, and most preferably 0.10 to 0.30 weight percent. An important advantage of the polysaccharide gum of this invention is that the gum greatly contributes to the necessary flow and rheological characteristics of a paste composition even though it is present in the paste in a relatively small amount. Further, since there is so little gum present, only a negligible amount of gum remains as residue after sintering or paste reflow.

The gum is dispersed in a homogeneous liquid medium which includes a solvent of the polysaccharide and a non-solvent of the polysaccharide. As employed herein, "dispersed" means partly or wholly dissolved and/or solvated.

The polysaccharide solvent is a true gum solvent which when heated with the gum, dissolves the gum into the solvent. The gum and solvent are heated to a minimum essential temperature which dissolves the gum into solution, but does not destroy or decompose the gum in any way. The degree of hydroxylation and the position of the hydroxyl groups on the solvent, may affect the ability of the gum to dissolve in the solvent at a temperature such that the structural characteristics of the gum are maintained. The gum and solvent solution in the absence of a non-solvent may have gel-like character, viscoelastic behavior, and pseudoplastic/thixotropic rheology, but these characteristics are not necessary for the gum and solvent to be suitable for use in this invention. Polysaccharide solvents suitable for use in this invention include but are not limited to ethanediols, propanediols, and propanetriols. Preferred polysaccharide solvents are 1,2-ethanediol (also known as ethylene glycol), 1,2-propanediol (also known as propylene glycol), 1,2,3-propanetriol (also known as glycerine) or mixtures thereof. The medium may contain one or more solvents. The amount of solvent in the liquid medium ranges from 2 to 50 weight percent, preferably 5 to 20 weight percent. The polysaccharide solvent must be miscible and form a homogeneous medium with a polysaccharide non-solvent.

The polysaccharide non-solvent is one which does not dissolve the gum at a temperature equal to the temperature at which the gum dissolves in the solvent. It provides substantially equal or enhanced viscosity, viscoelastic behavior, and pseudoplastic/thixotropic rheology than the gum-solvent solution alone. It is preferred to use as a non-solvent a liquid which is itself of high viscosity. An initial high viscosity in the liquid medium augments the development of the flow modification properties of the gum in the vehicle, i.e. the viscosity of the resulting vehicle is higher than either the solvent-gum solution or the non-solvent alone. Polysaccharide non-solvents suitable for use in this invention include but are not limited to hexanetriols, heptanetriols or mixtures thereof. Preferred polysaccharide non-solvents include hexanetriols, particularly prefered is 1,2,6-hexanetriol. It is interesting to note that polysaccharides may dissolve in 1,2,6-hexanetriol at a temperature low enough to preserve the integrity of the gum if the admixture is agitated for a long period of time, e.g., well in excess of about 5 hours. These circumstances are considered to be beyond normal operating procedures. Accordingly, 1,2,6-hexanetriol is included as a non-solvent. The non-solvent should be sufficiently hydroxylated in order to prevent precipitation of the polysaccharide in the medium. The medium may contain one or more non-solvents. The amount of non-solvent in the liquid medium ranges from 98 to 50 weight percent, preferably 95 to 80 weight percent.

The vehicle may also contain an active hydrogen-containing compound (activator) or a mixture of active hydrogen-containing compounds (activator system). An activator preferably becomes active at an elevated temperature to assist in the removal of surface oxides which may form on surface metals. An activator can also enhance solder flow, solder wetting, and should leave a non-corrosive residue. It is preferred that the activator be essentially fugitive leaving no or minimal residue after reflow. Active hydrogen-containing compounds include hydroxyl substituted amines, mono- and multi- basic acids, hydroxy acids and salts and or derivatives thereof. Hydroxyl substituted amines included aliphatic amines in which the hydroxyl and nitrogen are in vicinal relationship, hydroxyl substituted mononuclear aromatic amines in which the hydroxyl and nitrogen are in a vicinal relationship, hydroxyl substituted polynuclear heterocyclic amines in which the hydroxyl is in the two or eight position relative to the ring of nitrogen, and mixtures thereof. The term vicinal denotes neighboring or adjoining positions on a carbon ring or chain. Some suitable compounds include diethanolamine, triethanolamine, methyldiethanolamine, 2-(2-aminoethyl-amino) ethanol, diglycolamine, and other alkanol amines, 2-hydroxyquinoline, 8-hydroxyquinoline, alphahydroxymethylpyridine, and N-hydroxyethyl ethylenediamine. Mono- and multi- basic acids suitable for use in this invention include but are not limited to, formic acid, malonic acid, succinic acid, glutaric acid, hydroxy-acids, phenols and derivatives thereof. Particularly preferred activators are malonic acid, substituted malonic acids, and alkanolamines or mixtures thereof. The optional activator or activator system may be present in the amount of 0 to about 75 %, preferably 1 to 10% of the vehicle.

Optionally, the vehicle can include a small percentage of water, up to about 3 to 5 weight percent of the vehicle without significant detrimental effect on the paste system. The present vehicle can also contain minor amounts of other materials used in conventional fashion without departing from the concept of this invention. Such other materials include preservatives, modifiers, sequestrants, dispersion agents, antibacterial agents, and the like.

The vehicle is prepared by simply mixing the solvent and non-solvent components to form a homogeneous liquid medium, admixing the polysaccharide gum into the liquid medium with agitation, and heating to a temperature sufficient for the gum to disperse in the liquid medium.

Any well known technique for preparing the paste may be utilized. Application of the paste may be by conventional technique, typically stencil- or screen-printing. A satisfactory solder paste should print through a stencil designed for 50 mil (0.130 cm) pitch patterns, preferably 20 to 25 mil (0.051-0.0065 cm) pitch patterns or an 80-mesh (177 micron) or finer screen. A satisfactory thick film paste should print through a 200 to 400 mesh (74 to 37 micron) screen pattern. The paste should not drip between printing operations, nor should it dry or stiffen excessively when held on the screen or stencil for a reasonable period of time. For satisfactory performance the vehicle properties and paste composition should be adjusted to prevent excessive settling out of the powder, but not to interfere with the printing operation. Exclusion of air by blanketing the stencil or screen with an inert gaseous atmosphere and/or by dispensing the paste onto the stencil or screen as required may well enhance the overall performance of the paste.

The stencil or screen printable paste composition may be applied to any suitable substrate, particularly metal or ceramic substrates to form the desired paste. Thereafter, the paste is heated. Any atmosphere may be used e.g. air, but non-oxidizing atmospheres are preferred. Thick film pastes are heated to a temperature sufficient to volatilize the organic medium and sinter the inorganic particles. Solder pastes are heated to a temperature where the solder becomes molten and a highly adherent metallurgical and electrically conductive solder bond is formed.

Alternative to mixing the vehicle and inorganic particles prior to application to a substrate, the vehicle and the inorganic components may be applied separately. This method is particularly useful for the attachment of an electronic component to a printed wiring board wherein either the component or board is precoated with solder. A preferred vehicle for this attachment contains a composition for attaching a metallic lead of an electronic component to a metallization on a printed wiring board, wherein at least the lead or the printed wiring board metallization is precoated with solder, the composition comprising:
up to 1.0 weight % organo-soluble polysaccharide dispersed in
   a homogeneous liquid medium comprising:
      2 to 50 weight % polysaccharide solvent;
      98 to 50 weight % polyhydroxylated polysaccharide non-solvent; and an activator.

### EXAMPLES

The following examples are used to illustrate this invention without limitation. All percentages are by weight unless otherwise specified.

In the following examples the following designations have the following identities:

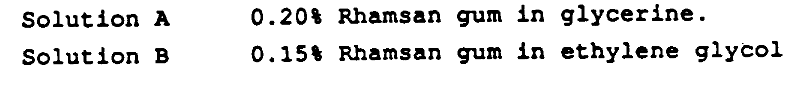

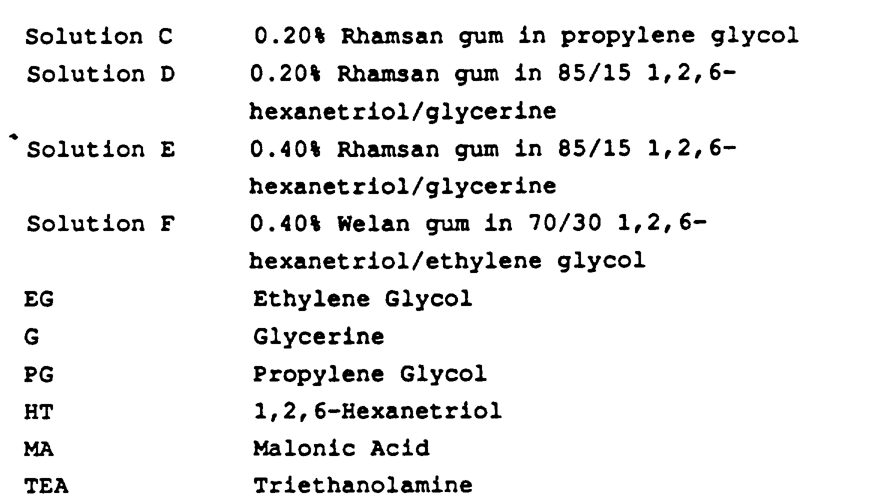

Rhamsan and welan gums were supplied by Kelco Division of Merck and Company, San Diego, California.

The gum solutions, which were gels at room temperature, were made by heating and agitating the powdered gum in the respective liquid medium to a maximum temperature of 125°C, for approximately 1 hour.

The pastes of the following examples were made by hand mixing a metal powder of 62/36/2 tin/lead/silver (Sn/Pb/Ag), -325 mesh (44 micron) to +500 mesh (approximately 25 micron), with one of the Solutions A through F and additional gum solvent or mixture of gum non-solvent and gum solvent, to produce approximately 15 grams of the composition.

Viscosities were measured at 25°C using a Brookfield Digital Viscometer, Model HBTD, sample holder #6, spindle #SC4-14. Viscosity is reported as centipoise (1 centipoise = 1 mPa˙s) (x 10⁻³) @ 1 sec⁻¹. The flow index reported is the slope of the line resulting from a plot of viscosity in centipoise versus the shear rate in reciprocal seconds. It is desirable to have pseudoplastic rheology, i.e., a high viscosity at low shear rate and a lower viscosity at a higher shear rate. The slope of the line plotted will be negative, and the larger the absolute value of the the slope, the greater the degree of pseudoplasticity. Printing resolution was determined by using the paste to print two pad patterns 13 and 25 mils (0.033 and 0.065 cm) wide, both 85 mils (0.22 cm) long, on a pitch ranging from 20 to 60 mils (0.051 to 0.15 cm) on an FR4 board, using an 8 mil (0.020 cm) thick stencil. The resolution was the width in mils (cm) of the smallest initial space between adjacent pads which did not fill in with paste; thus the smaller the space the better the resolution. Additional characteristics of the pastes are noted in the appropriate examples.

### Comparative Example A and B

Comparative Examples A and B demonstrate the resulting poor performance of pastes made without gum even when viscosity of the paste was high. The gum solution and the paste composition were prepared as described above according to the following

| | Example A | Example B |
|---|---|---|
| Wt % Metal in Paste | 91.3 | 92.0 |
| Gum Solution | - | - |
| Paste Medium | HT/G | HT/G |
| Solvent Ratio | 93/7 | 93/7 |
| Wt% Gum in Vehicle | 0 | 0 |
| Wt % MA in Vehicle | 0 | 0 |
| Wt % TEA in Vehicle | 0 | 0 |
| Viscosity | 110 | 335 |
| Flow Index | -0.20 | -0.35 |
| Resolution | 20 (0.051) | Not Printable |

Comparative Example A had only modest viscosity and provided poor resolution. The poor resolution was due to the paste exhibiting Newtonian flow at low shear rates, in that the printed paste ran on the board. In Example B, the increased viscosity and solids content of the paste made the paste unprintable as it would not transfer through the stencil.

### Comparative Examples C, D, and E

Comparative Examples C, D, and E demonstrate the poor performance of pastes made with a polysaccharide gum dispersed in true solvents of the gum. The gum solution and the paste composition were prepared as described above according to the following

| | Example C | Example D | Example E |
|---|---|---|---|
| Wt % Metal in Paste | 91.3 | 91.3 | 91.3 |
| Gum Solution | B | C | A |
| Paste Medium | EG | PG | G |
| Solvent Ratio | - | - | - |
| Wt% Gum in Vehicle | 0.09 | 0.09 | 0.09 |
| Wt % MA in Vehicle | 0 | 0 | 0 |
| Wt % TEA in Vehicle | 0 | 0 | 0 |
| Viscosity | 33 | 1.9 | 109 |
| Flow Index | -0.51 | -0.08 | -0.21 |
| Resolution | Not Printable | Not Printable | 14 (.036) |

The viscosity of the pastes of Example C and Example D were extremely low and the pastes were too fluid to be printed. In addition, the metal powder rapidly settled to the bottom of the container and packed into a hard mass. The paste of Example E which used glycerine as the solvent provided somewhat higher viscosity but gave only fair resolution and was excessively hygroscopic.

### Examples 1, 2, 3, and 4

Examples 1 through 4 demonstrate pastes of this invention made with a polysaccharide gum in low concentration dispersed in a preferred gum non-solvent and solvent medium. The gum solution and the paste composition were prepared as described above according to the following

| | Example 1 | Example 2 | Example 3 | Example 4 |
|---|---|---|---|---|
| Wt % Metal in Paste | 91.3 | 91.3 | 91.3 | 91.6 |
| Gum Solution | D | D | D | D |
| Paste Medium | HT/G | HT/G | HT/G | HT/G |
| Solvent Ratio | 93/7 | 93/7 | 85/15 | 85/15 |
| Wt% Gum in Vehicle | 0.09 | 0.09 | 0.09 | 0.09 |
| Wt % MA in Vehicle | 0 | 4.8 | 0 | 4.8 |
| Wt % TEA in Vehicle | 0 | 0 | 0 | 0 |
| Viscosity | 251 | 223 | 185 | 282 |
| Flow Index | -0.38 | -0.23 | -0.32 | -0.26 |
| Resolution | 11 (.028) | 11 | 9 (.023) | 11 |

In Examples 1 through 4, the viscosity was substantially increased above the viscosities of Comparative Examples C through D, resolution was very good, and the paste did not settle. The presence of malonic acid activator in Examples 2 and 4 did not significantly detract from paste performance. The hygroscopicity was reduced relative to glycerine of Example E by the substantial replacement of the glycerine by 1,2,6-hexanetriol. Tack was demonstrated by printing small solder pads with the pastes of Examples 1 through 4, with an AMI Printer, Model 1803 through a 10 mil thick (0.0254 cm) stencil onto 40 by 50 mil (0.102 by 0.127 cm) solder coated copper pads on an FR4 laminate, placing 8 and 14 pin dual-in-line packages made by Signetics, (Model numbers SMC14580 and SLM339D8745 respectively) on the wet solder paste and inverting the assembly. Only the tack of the wet solder paste held the packages in place. The packages did not fall off the board after 16 hours in the inverted position.

### Examples 5, 6, 7, and 8

Examples 5 through 8 demonstrate pastes of this invention with the polysaccharide gum in higher concentration than Examples 1 through 4. The gum solution and the paste composition were prepared as described above according to the following

| | Example 5 | Example 6 | Example 7 | Example 8 |
|---|---|---|---|---|
| Wt % Metal in Paste | 91.3 | 91.3 | 91.3 | 91.3 |
| Gum Solution | E | E | E | E |
| Paste Medium | HT/G | HT/G | HT/G | HT/G |
| Solvent Ratio | 93/7 | 93/7 | 85/15 | 85/15 |
| Wt% Gum in Vehicle | 0.18 | 0.18 | 0.18 | 0.18 |
| Wt % MA in Vehicle | 0 | 4.8 | 0 | 4.8 |
| Wt % TEA in Vehicle | 0 | 0 | 0 | 0 |
| Viscosity | 302 | 169 | 285 | 185 |
| Flow Index | -0.25 | -0.32 | -0.26 | -0.32 |
| Resolution | 9 | 9 | 11 | 11 |

The incorporation of the malonic acid activator in Examples 6 and 8 increased the pseudoplastic flow index. Good resolution was obtained. The paste of Examples 6 and 8 were printed onto copper pads, which were previously hot air solder leveled (HASL), on an FR4 laminate and the parts reflowed in a Watkins-Johnson 11-zone nitrogen furnace Model 6C-96N(S) for approximately 23 minutes to a maximum temperature of about 210°C. The parts emerged dry from the furnace with an extremely low level of residue on or around the solder bumps as determined by examination with 50x magnification. Only a few very small solder balls were present.

### Example 9

Example 9 demonstrates a paste of this invention using a different activator than in Examples 6 and 8. The gum solution and the paste composition were prepared as described above according to the following

| | Example 9 |
|---|---|
| Wt % Metal in Paste | 91.3 |
| Gum Solution | E |
| Paste Medium | HT/G |
| Solvent Ratio | 90/10 |
| Wt% Gum in Vehicle | 0.18 |
| Wt % MA in Vehicle | 0 |
| Wt % TEA in Vehicle | 30 |
| Viscosity | 191 |
| Flow Index | -0.29 |
| Resolution | 9 |

The paste of Example 9 was reflowed on parts as in Examples 6 and 8. The reflowed solder was bright and dry emerging from the reflow furnace, showed excellent wetting, and very little residue. The parts were almost completely free of solder balls.

### Example 10

This example demonstrates a paste of this invention using welan gum. The gum solution and the paste composition were prepared as described above according to the following

| | Example 10 |
|---|---|
| Wt % Metal in paste | 91.6 |
| Gum Solution | F |
| Paste Medium | HT/EG |
| Solvent Ratio | 85/15 |
| Wt% Gum in Vehicle | 0.18 |
| Wt % MA in Vehicle | 5.1 |
| Wt % TEA in Vehicle | 0 |
| Viscosity | 256 |
| Flow Index | -0.28 |
| Resolution | 9 |

Printability was good. The parts made with the paste of Example 10 and reflowed as in Examples 6 and 8, were dry and showed complete solder wetting, essentially no solder balls and very little residue.

## Claims

1. An organic vehicle for electronic compositions comprising:
organo-soluble polysaccharide gum dispersed in a homogeneous liquid medium comprising:
2 to 50 weight % organic solvent which, when heated with the polysaccharide to a minimum essential temperature, dissolves the polysaccharide into solution without destroying or decomposing the polysaccharide; and
98 to 50 weight % 1, 2, 6-hexanetriol, or a polyhydroxylated liquid which does not dissolve the polysaccharide at a temperature equal to said minimum essential temperature, or mixtures thereof;
the polysaccharide gum being present in the electronic composition in an amount up to 1.0 weight %.

2. The organic vehicle of Claim 1 wherein the organo-soluble polysaccharide is selected from the group consisting of rhamsan, welan, xanthan, agar, hypnean, funoran, gum arabic, gum karaya, gum tragacanth, and pectin gums.

3. The organic vehicle of Claim 2 wherein the organo-soluble polysaccharide is selected from the group consisting of rhamsan and welan gums.

4. The organic vehicle of Claim 1 wherein the polysaccharide solvent is selected from the group consisting of glycerine, propylene glycol, and ethylene glycol.

5. The organic vehicle of Claim 1 wherein the polyhydroxylated polysaccharide non-solvent is selected from the group consisting of hexanetriols.

6. The organic vehicle of Claim 4 wherein the polyhydroxylated polysaccharide non-solvent is 1,2,6-hexanetriol.

7. An electronic paste composition comprising:
65 to 93 weight % finely divided inorganic particles suspended in an organic vehicle for electronic compositions comprising:
organo-soluble polysaccharide gum dispersed in a homogeneous liquid medium comprising:
2 to 50 weight % organic solvent which, when heated with the polysaccharide to a minimum essential temperature, dissolves the polysaccharide into solution without destroying or decomposing the polysaccharide; and
98 to 50 weight % 1, 2, 6-hexanetriol, or a polyhydroxylated liquid which does not dissolve the polysaccharide at a temperature equal to said minimum essential temperature, or mixtures thereof;
the polysaccharide gum being present in the electronic composition in an amount up to 1.0 weight %.

8. The electronic paste composition of Claim 7 wherein the organo-soluble polysaccharide is selected from the group consisting of rhamsan, welan, xanthan, agar, hypnean, funoran, gum arabic, gum karaya, gum tragacanth, and pectin gums .

9. The electronic paste composition of Claim 8 wherein the organo-soluble polysaccharide is selected from the group consisting of rhamsan and welan.

10. The electronic paste composition of Claim 7 wherein the polysaccharide solvent is selected from the group consisting of glycerine, propylene glycol, and ethylene glycol.

11. The electronic paste composition of Claim 7 wherein the polyhydroxylated polysaccharide non-solvent is selected from the group consisting of hexanetriols.

12. The electronic paste composition of Claim 11 wherein the polyhydroxylated polysaccharide non-solvent is 1,2, 6-hexanetriol.

13. The electronic paste composition of Claim 7 wherein the vehicle further comprises an activator.

14. The electronic paste composition of Claim 7 wherein the inorganic particles are selected from the group consisting of tin, lead, silver, indium, bismuth, and mixtures thereof.

15. The electronic paste composition of Claim 7 wherein the inorganic particles comprise 75 to 90 weight % of the composition and are selected from the group consisting of copper, silver, gold, platinum, palladium, and mixtures thereof.

16. The electronic paste composition of Claim 7 wherein the inorganic particles comprise 65 to 90 weight % of the composition and are selected from the group consisting of alumina and borosilicates.

17. Use of a composition according to claims 1 to 6 for attaching a metallic lead of an electronic component to a metallization on a printed wiring board, wherein at least the lead or the printed wiring board metallization is precoated with solder, and the composition and an activator.

## Patentansprüche

1. Organisches Hilfsmittel für elektronische Zusammensetzungen, umfassend:
ein in organischen Lösungsmitteln lösliches Polysaccharid-Gummi, dispergiert in einem homogenen flüssigen Medium, umfassend:
2 bis 50 Gew.-% eines organischen Lösungsmittels, das, wenn es zusammen mit dem Polysaccharid auf eine essentielle Mindesttemperatur erhitzt wird, das Polysaccharid löst, ohne das Polysaccharid zu zerstören oder zu zersetzen; und
98 bis 50 Gew.-% 1,2,6-Hexantriol oder eine polyhydroxylierte Flüssigkeit, die das Polysaccharid bei einer Temperatur, die gleich der essentiellen Mindesttemperatur ist, nicht löst, oder Mischungen davon;
wobei das Polysaccharid-Gummi in der elektronischen Zusammensetzung in einer Menge bis zu 1,0 Gew.-% vorhanden ist.

2. Organisches Hilfsmittel nach Anspruch 1, wobei das in organischen Lösungsmitteln lösliche Polysaccharid aus der aus Rhamsan, Welan, Xanthan, Agar, Hypnean, Funoran, Gummi arabicum, Karayhagummi, Tragantgummi und Pektingummis bestehenden Gruppe ausgewählt ist.

3. Organisches Hilfsmittel nach Anspruch 2, wobei das in organischen Lösungsmitteln lösliche Polysaccharid aus der aus Rhamsan- und Welan-Gummen bestehenden Gruppe ausgewählt ist.

4. Organisches Hilfsmittel nach Anspruch 1, wobei das Polysaccharid-Lösungsmittel aus der aus Glycerin, Propylenglycol und Ethylenglycol bestehenden Gruppe ausgewählt ist.

5. Organisches Hilfsmittel nach Anspruch 1, wobei das polyhydroxylierte Nichtlösungsmittel für Polysaccharide aus der aus Hexantriolen bestehenden Gruppe ausgewählt wird.

6. Organisches Hilfsmittel nach Anspruch 4, wobei das polyhydroxylierte Nichtlösungsmittel für Polysaccharide 1,2,6-Hexantriol ist.

7. Elektronische Pasten-Zusammensetzung, umfassend:
65 bis 93 Gew.-% fein zerteilte Teilchen, suspendiert in einem organischen Hilfsmittel für elektronische Zusammensetzungen, umfassend:
ein in organischen Lösungsmitteln lösliches Polysaccharid-Gummi, dispergiert in einem homogenen flüssigen Medium, umfassend:
2 bis 50 Gew.-% eines organischen Lösungsmittels, das, wenn es zusammen mit dem Polysaccharid auf eine essentielle Mindesttemperatur erhitzt wird, das Polysaccharid löst, ohne das Polysaccharid zu zerstören oder zu zersetzen; und
98 bis 50 Gew.-% 1,2,6-Hexantriol oder eine polyhydroxylierte Flüssigkeit, die das Polysaccharid bei einer Temperatur, die gleich der essentiellen Mindesttemperatur ist, nicht löst, oder Mischungen davon;
wobei das Polysaccharid-Gummi in der elektronischen Zusammensetzung in einer Menge bis zu 1,0 Gew.-% vorhanden ist.

8. Elektronische Pasten-Zusammensetzung nach Anspruch 7, wobei das in organischen Lösungsmitteln lösliche Polysaccharid aus der aus Rhamsan, Welan, Xanthan, Agar, Hypnean, Funoran, Gummi arabicum, Karayhagummi, Tragantgummi und Pektingummis bestehenden Gruppe ausgewählt ist.

9. Elektronische Pasten-Zusammensetzung nach Anspruch 8, wobei das in organischen Lösungsmitteln lösliche Polysaccharid aus der aus Rhamsan und Welan bestehenden Gruppe ausgewählt ist.

10. Elektronische Pasten-Zusammensetzung nach Anspruch 7, wobei das Polysaccharid-Lösungsmittel aus der aus Glycerin, Propylenglycol und Ethylenglycol bestehenden Gruppe ausgewählt ist.

11. Elektronische Pasten-Zusammensetzung nach Anspruch 7, wobei das polyhydroxylierte Nichtlösungsmittel für Polysaccharide aus der aus Hexantriolen bestehenden Gruppe ausgewählt wird.

12. Elektronische Pasten-Zusammensetzung nach Anspruch 11, wobei das polyhydroxylierte Nichtlösungsmittel für Polysaccharide 1,2,6-Hexantriol ist.

13. Elektronische Pasten-Zusammensetzung nach Anspruch 7, wobei das Hilfsmittel weiterhin einen Aktivator umfaßt.

14. Elektronische Pasten-Zusammensetzung nach Anspruch 7, wobei die anorganischen Teilchen aus der aus Zinn, Blei, Silber, Indium, Wismut, und Mischungen davon bestehenden Gruppe ausgewählt sind.

15. Elektronische Pasten-Zusammensetzung nach Anspruch 7, wobei die anorganischen Teilchen 75 bis 90 Gew.-% der Zusammensetzung umfassen und aus der aus Kupfer, Silber, Gold, Platin, Palladium und Mischungen davon bestehenden Gruppe ausgewählt sind.

16. Elektronische Pasten-Zusammensetzung nach Anspruch 7, wobei die anorganischen Teilchen 65 bis 90 Gew.-% der Zusammensetzung umfassen und aus der aus Aluminiumoxid und Borosilikaten bestehenden Gruppe ausgewählt sind.

17. Verwendung einer Zusammensetzung nach den Ansprüchen 1 bis 6 zum Befestigen einer metallischen Leitung eines elektronischen Bauteils an einer Metallisierung auf einer gedruckten Verdrahtungsplatte, wobei wenigstens der Draht oder die Metallisierung der gedruckten Verdrahtungsplatte mit Lötmittel und der Zusammensetzung und dem Aktivator vorbeschichtet ist.

## Revendications

1. Véhicule organique pour compositions électroniques comprenant:
une gomme de polysaccharide organo-soluble dispersée dans un milieu liquide homogène comprenant:
2 à 50% en poids de solvant organique qui, lorsqu'il est chauffé avec le polysaccharide jusqu'à une température nécessaire minimale, dissout le polysaccharide dans la solution sans détruire ou décomposer le polysaccharide; et
98 à 50% en poids de 1,2,6-hexanetriol, ou d'un liquide polyhydroxylé qui ne dissout pas le polysaccharide à une température égale à ladite température nécessaire minimale, ou de mélanges de ceux-ci;
la gomme de polysaccharide étant présente dans la composition électronique en une quantité pouvant atteindre 1,0% en poids.

2. Le véhicule organique selon la revendication 1, dans lequel le polysaccharide organo-soluble est choisi dans le groupe constitué de rhamsane, welane, xanthane, agar, hypneane, funorane, gomme arabique, gomme karaya, gomme adragante, et gommes de pectine.

3. Le éhicule organique selon la revendication 2, dans lequel le polysaccharide organo-soluble est choisi dans le groupe constitué de gommes de rhamsane et de welane.

4. Le véhicule organique selon la revendication 1, dans lequel le solvant de polysaccharide est choisi dans le groupe constitué de glycérine, propylène glycol, et éthylène glycol.

5. Le véhicule organique selon la revendication 1, dans lequel le non-solvant de polysaccharide polyhydroxylé est choisi dans le groupe constitué d'hexanetriols.

6. Le véhicule organique selon la revendication 4, dans lequel le non-solvant de polysaccharide polyhydroxylé est du 1,2,6-hexanetriol.

7. Une composition de pâte électronique comprenant:
65 à 93% en poids de particules inorganiques finement divisées en suspension dans
un véhicule organique pour compositions électroniques comprenant:
une gomme de polysaccharide organo-soluble dispersée dans un milieu liquide homogène comprenant:
2 à 50% en poids de solvant organique qui, lorsqu'il est chauffé avec le polysaccharide jusqu'à une température nécessaire minimale, dissout le polysaccharide dans la solution sans détruire ni décomposer le polysaccharide; et
98 à 50% en poids de 1,2,6-hexanetriol, ou d'un liquide polyhydroxylé qui ne dissout pas le polysaccharide à une température égale à ladite température nécessaire minimale, ou de mélanges de ceux-ci;
la gomme de polysaccharide étant présente dans la composition électronique en une quantité pouvant atteindre 1,0% en poids.

8. La composition de pâte électronique selon la revendication 7, dans laquelle le polysaccharide organo-soluble est choisi dans le groupe constitué de rhamsane, welane, xanthane, agar, hypneane, funorane, gomme arabique, gomme karaya, gomme adragante, et gommes de pectine.

9. La composition de pâte électronique selon la revendication 8, dans laquelle le polysaccharide organo-soluble est choisi dans le groupe constitué de rhamsane et welane.

10. La composition de pâte électronique selon la revendication 7, dans laquelle le solvant de polysaccharide est choisi dans le groupe constitué de glycérine, propylène glycol , et éthylène glycol.

11. La composition de pâte électronique selon la revendication 7, dans laquelle le non-solvant polyhydroxylé de polysaccharide est choisi dans le groupe constitué d'hexanetriols.

12. La composition de pâte électronique selon la revendication 11, dans laquelle le non-solvant de polyhydroxylé polysaccharide est du 1,2,6-hexanetriol.

13. La composition de pâte électronique selon la revendication 7, dans laquelle le véhicule comprend en outre, un activateur.

14. La composition de pâte électronique selon la revendication 7, dans laquelle les particules inorganiques sont choisies dans le groupe constitué de, étain, plomb, argent, indium, bismuth, et leurs mélanges.

15. La composition de pâte électronique selon la revendication 7, dans laquelle les particules inorganiques constituent 75 à 90% en poids de la composition, et sont choisies dans le groupe constitué de, cuivre, argent, or, platine, palladium, et leurs mélanges de ceux-ci.

16. Composition de pâte électronique selon la revendication 7, dans laquelle les particules inorganiques constituent 65 à 90% en poids de la composition, et sont choisies dans le groupe constitué par alumine et borosilicates.

17. Utilisation d'une composition selon les revendications 1 à 6 pour fixer un conducteur métallique d'un composant électronique sur une métallisation d'une carte de câblage imprimé, dans laquelle au moins le conducteur ou la métallisation de la carte de câblage imprimé est recouvert au préalable de soudure, et de la composition et d'un activateur.
